# FASCICULE DE BREVET EUROPEEN

(11) **EP 2 619 901 B1**
(45) Date de publication et mention de la délivrance du brevet: **07.01.2015**
(21) Numéro de dépôt: 11761336.4
(22) Date de dépôt: 20.09.2011
(51) Int. Cl.: H03F 1/26, H03F 3/189, H04B 1/08, H04B 1/10

(54) **AMPLIFICATEUR FAIBLE BRUIT CRYOGENIQUE**
KRYOGENER RAUSCHARMER VERSTÄRKER
CRYOGENIC LOW NOISE AMPLIFIER

(30) Priorité: 20.09.2010 FR 1057507
(43) Date de publication de la demande: 31.07.2013
(73) Titulaire: Callisto France, 31290 Villefranche de Lauragais (FR)
(72) Inventeur: RAWSON, Stephen, F-11320 Labastide D'anjou (FR); FAUROUX, Benoît, F-11400 Castelnaudary (FR); RAYET, Rémi, F-31400 Toulouse (FR); BONHOURE, Thomas, F-31290 Avignonet-Lauragais (FR); CHAMBON, Cédric, F-31290 Villefranche de Lauragais (FR)
(74) Mandataire: Maupilier, Didier
(86) Numéro de dépôt international: PCT/EP2011/066280
(87) Numéro de publication internationale: WO 2012/038400

(56) Documents cités:
- EP-A2- 1 427 112
- GB-A- 2 343 090
- US-A- 6 104 934
- US-A1- 2002 053 215
- US-A1- 2003 084 677
- US-A1- 2005 020 229
- US-B1- 6 622 028
- ORFEI A ET AL: "A Multi-Feed Receiver in the 18 to 26.5 GHz Band for Radio Astronomy", IEEE ANTENNAS AND PROPAGATION MAGAZINE, IEEE SERVICE CENTER, PISCATAWAY, NJ, US, vol. 52, no. 4, 1 août 2010 (2010-08-01), pages 62-72, XP011320721, ISSN: 1045-9243

## Description

La présente invention appartient au domaine des systèmes de réception terrestre de signaux radiofréquences de faible puissance.

Plus particulièrement l'invention concerne un amplificateur faible bruit et hautes fréquences adapté à la réception des signaux faibles émis par des véhicules spatiaux pouvant être à de grandes distances de la Terre.

En matière de communications dans le domaine radiofréquence, il est parfois nécessaire de détecter et amplifier des signaux de très faibles puissances.

Cette situation se trouve en particulier dans les cas où l'émetteur des signaux se situe à de grandes distances ou dans de mauvaises conditions d'émission.

Pour ces raisons la communication avec des sondes interplanétaires, dont certaines sont aujourd'hui aux confins du système solaire à plus d'un milliard de kilomètres, s'avère toujours très difficile du fait que les signaux émis sont très atténués en raison des grandes distances entre l'émetteur et la Terre et des imperfections de pointage de l'antenne de l'émetteur, inévitables compte tenu des exigences de précision angulaire correspondant à ces distances.

Dans l'impossibilité d'augmenter la puissance de l'émetteur, dont les performances ne sont plus modifiables et sont souvent limitées en elles-mêmes compte tenu des contraintes qui s'imposent aux sondes interplanétaires, les solutions portent sur l'amélioration de la sensibilité des chaînes de réception installée au sol, sur Terre aujourd'hui.

Une première solution pour améliorer cette sensibilité consiste à augmenter la taille de l'antenne de la chaîne de réception. Pour cela, à fréquence donnée, il est connu d'améliorer le gain G de l'antenne et donc la sensibilité de la chaîne de réception en augmentant les dimensions de l'antenne et en multipliant le nombre de réflecteurs mis en oeuvre par cette antenne.

Cette solution trouve cependant des limites technologiques et économiques. Il est en effet technologiquement délicat de pointer une antenne de grandes dimensions, également de masse importante, avec une grande précision d'autant plus exigée que le faisceau d'une antenne est, à fréquence donnée, plus fin et plus étroit lorsque les dimensions de l'antenne augmentent.

Le coût et les contraintes qui pèsent sur les antennes de grandes dimensions et sur leurs dispositifs d'orientation et de pointage s'avèrent donc très pénalisant pour de telles solutions voire rédhibitoire lorsque l'émetteur est défilant et que l'antenne doit réaliser la poursuite de la cible, cas général du fait de la rotation de la Terre lorsque la réception doit être réalisée sur une période de temps non négligeable.

Une autre solution, le plus souvent combiné avec la solution précédente, consiste à réduire au mieux le bruit de l'électronique de la chaîne de réception et en particulier de sa partie radiofréquence qui est la plus sensible et à l'origine de la dégradation du rapport signal sur bruit.

Outre le choix de composants de qualité, la réduction du bruit est obtenue en refroidissant à basse température les composants physiques de l'amplificateur situé dans la tête de réception de l'antenne et réduire ainsi le bruit électronique d'origine thermique défini comme la température de bruit T.

Pour les besoins de récepteurs sensibles, il est ainsi connu de refroidir l'amplificateur à des températures cryogéniques de l'ordre de quelques Kelvins, typiquement moins de 20 K.

Des exemples peuvent être trouvés dans les documents de brevet EP 1 427 112, US 2005/020229, US 6 622 028, US 2003/084677, GB 2 343 090, US 2002/053215, US 6 104 934 et dans Orfei et al., "A Multi-Feed Receiver in the 18 to 26.5 GHz Band for Radio Astronomy", IEEE Antennas and Propagation Magazine, vol. 52, no. 4, 1 août 2010.

Cependant amener la température d'un amplificateur radiofréquences en fonctionnement à des températures aussi basses et maintenir ces conditions pendant toute la durée de fonctionnement de l'amplificateur est complexe et nécessite la mise en oeuvre de matériels fragiles et coûteux qui exigent des interventions de maintenance fréquentes pour fonctionner avec les performances recherchées.

Si la combinaison de ces deux solutions pour améliorer le facteur de mérite G/T du système de réception permet aujourd'hui d'assurer des liaisons de télécommunication avec une sonde lointaine, il s'avère cependant que la

complexité des technologies mises en jeux est très pénalisante tant pour les coûts de mise en place et de fonctionnement que vis à vis des contraintes opérationnelles en particulier des opérations de maintenance qui réduisent la disponibilité du système.

Afin de palier aux défauts des systèmes existants et d'améliorer la disponibilité opérationnelle d'un amplificateur radiofréquences particulièrement adapté pour recevoir des signaux de faibles énergies et de réduire les coûts de maintenance de ce système, l'invention propose de réaliser un amplificateur à faible bruit cryogénique dans lequel la mise en température cryogénique et le maintien à la température de fonctionnement sont simplifiées par rapport aux amplificateurs cryogéniques connus.

L'amplificateur radiofréquences de l'invention destiné à être mis en oeuvre dans un dispositif de réception d'un signal radiofréquences de faible puissance comporte un amplificateur faible bruit maintenu dans un espace hermétique délimité par l'enceinte d'un cryostat et dans lequel espace est maintenue une pression intérieure réduite par rapport à la pression atmosphérique extérieure. L'amplificateur faible bruit reçoit des signaux à amplifier d'un coupleur d'entrée traversant l'enceinte de manière étanche et transmet les signaux amplifiés par un coupleur de sortie traversant l'enceinte également de manière étanche, et l'espace intérieur de l'enceinte est refroidi au moyen d'une tête froide qui réalise le pompage de la chaleur à l'intérieur de l'enceinte.

Dans l'amplificateur radiofréquence de l'invention :
- les coupleurs d'entrée et de sortie sont réalisés pour une partie structurale avec un matériau de conductivité thermique égale ou inférieure à 50W/m.K et pour une partie électriquement conductrice par un plaquage avec un matériau de conductivité électrique supérieure à 10E7 Siemens/m ;
- la pression initiale intérieure dans l'enceinte du cryostat correspond, avant la diminution de la température, à une pression d'un vide peu poussé comprise entre la pression atmosphérique et 10 Pa ;
- l'espace hermétique délimité par l'enceinte du cryostat est remplie d'un matériau isolant thermique nanostructuré à base de silice sous forme d'aérogel,
- la tête froide comporte au moins deux étages dont des terminaisons froides sont à des températures cryogéniques différentes, un étage terminal fonctionnant à une température proche de la température à laquelle l'amplificateur faible bruit doit fonctionner, par exemple aux environs de 15K, et au moins un étage intermédiaire fonctionnant à une température intermédiaire entre la température de l'étage terminal et une température ambiante, par exemple aux environs de 50 K. La terminaison froide terminale de l'étage terminal de la tête froide est thermiquement reliée à l'amplificateur faible bruit de sorte à réaliser un pompage de la chaleur dudit amplificateur faible bruit à la plus basse température possible et une terminaison froide intermédiaire du ou au moins d'un des étages intermédiaires est thermiquement reliée à des structures support ou des éléments internes de l'amplificateur à l'intérieur de l'enceinte du cryostat de sorte à réaliser un pompage de la chaleur diffuse à l'intérieur de l'enceinte.

Par cet agencement des éléments composant l'amplificateur radiofréquences il est possible de limiter les pertes thermiques et de faire fonctionner l'amplificateur faible bruit et l'ensemble de la chaîne d'amplification à la température cryogénique suffisante pour réduire les bruits thermiques de la chaîne d'amplification en ayant réalisé à la température ambiante un vide primaire ou vide peu poussé dans l'enceinte du cryostat contrairement à un amplificateur cryogénique conventionnel qui exige de réaliser un vide secondaire ou vide poussé.

Suivant les fréquences des signaux devant être amplifiés et les performances recherchées pour l'amplificateur, les coupleurs d'entrée et ou de sortie peuvent être du type à guide d'onde ou du type à câble coaxial, voire avec des transitions de média de propagation à l'intérieur du cryostat mais dans tous les cas pour éviter les pertes thermiques par conduction il est retenu :
- qu'un guide d'onde, traversant de manière étanche une paroi de l'enceinte du cryostat au niveau d'une fenêtre guide d'ondes, comporte des parois dont la structure est réalisée avec un matériau à conductivité thermique égale ou inférieure à 50W/m.K et dont la surface interne est recouverte d'un plaquage d'un matériau de conductivité électrique supérieure à 10E7 Siemens/m, plaquage d'une épaisseur aussi mince que possible pouvant être inférieur à un micromètre compte tenu des fréquences en jeu ;
- qu'un câble coaxial, traversant de manière étanche une paroi de l'enceinte du cryostat au niveau d'une prise coaxiale, comporte un conducteur central réalisée avec le matériau à conductivité thermique égale ou inférieure à 50W/m.K et dont la surface externe du conducteur central est recouverte d'un plaquage d'un matériau de conductivité électrique supérieure à 10E7 Siemens/m et comporte un blindage réalisée dans un matériau métallique à conductivité thermique égale ou inférieure à 50W/m.K.

Pour obtenir la résistance thermique la plus élevée possible, le matériau à conductivité thermique égale ou inférieure à 50W/m.K est sélectionné parmi les matériaux métalliques appartenant à la famille des aciers inoxydables ou des alliages fer-nickel comportant environ 36% de nickel type Invar®, ou de préférence un matériau céramique ou un matériau composite comportant des fibres maintenues dans une résine durcie permettant d'atteindre des résistance thermiques plus élevées mais pour des coûts de mise en oeuvre également plus élevés.

Pour obtenir les meilleures performances électriques, mais également profiter de l'aptitude de ces métaux à être déposés en couches minces de quelques micromètres ou de moins de un micromètre, le matériau de conductivité électrique supérieure à 10E7 Siemens/m est avantageusement choisi parmi la famille des métaux ou alliages métalliques comportant de l'argent Ag, de l'or Au ou du cuivre Cu.

Afin de permettre un montage et un démontage rapide de la tête froide sans risquer d'endommager les composants à l'intérieur du cryostat et sans risquer de détériorer les moyens d'étanchéité de l'enceinte du cryostat, la tête froide est fixée à l'enceinte du cryostat depuis l'extérieur du cryostat par l'intermédiaire d'une douille solidaire de manière étanche de l'enceinte.

L'obtention de ce résultat est renforcée par la structure de la douille qui comporte une douille interne formant un fourreau traversant l'enceinte au niveau d'une ouverture dans lequel sont maintenus les étages intermédiaires et l'étage terminal de la tête froide.

Afin de limiter les interfaces de la tête froide à des parties à l'intérieur du cryostat ne risquant que peu d'être endommagées par les montages et démontages successifs de la tête froide, la douille interne comporte des liens thermiques, lesquels liens thermiques sont agencés pour obtenir une continuité thermique avec les structures support et ou des éléments internes de l'amplificateur, lesquels liens thermiques sont chacun en continuité thermique, c'est à dire avec une surface de contact physique suffisante et une pression de contact ou un serrage à froid également suffisant pour assurer le contact intime nécessaire à la faible résistance thermique permettant la conduction du flux de la chaleur devant être extraite, avec une terminaison froide de la tête froide de sorte à assurer la continuité thermique entre les terminaisons froides de la tête froide et les éléments internes au cryostat devant être refroidis.

Pour éviter des pertes thermiques excessives par la douille, la douille interne comporte des lumières de communication entre le volume intérieur du fourreau formé par la douille interne et le volume intérieur de l'enceinte du cryostat, lumières qui assurent que le vide primaire est également établi dans le volume intérieur de la douille mais dont les dimensions sont suffisamment petites pour éviter que le matériau isolant thermique sous forme d'aérogel remplissant l'espace intérieure de l'enceinte du cryostat pénètre dans le volume intérieur de la douille par lesdites lumières.

Les performances de la chaîne d'amplification sont encore améliorées autant que de besoin en intégrant des composants accessoires agencés dans le cryostat pour être maintenus à température cryogénique. Ces composants sont par exemple des filtres agissant sur la bande passante des signaux, des isolateurs agissant sur les réflexions des signaux, des coupleurs de signaux.

Pour diminuer les temps d'intervention lorsqu'il est nécessaire de démonter la tête froide et donc d'attendre que l'intérieur du cryostat soit revenu à une température proche de la température ambiante, avantageusement un système de réchauffage de l'amplificateur radiofréquences est agencé à l'intérieur de l'enceinte du cryostat.

La description de l'invention est faite en référence aux figures qui illustrent schématiquement et de manière non limitative :
- figure 1: une vue générale en perspective d'un amplificateur de l'invention ;
- figure 2: une vue en perspective de l'amplificateur de la figure un sans la partie latérale de l'enveloppe du cryostat ;

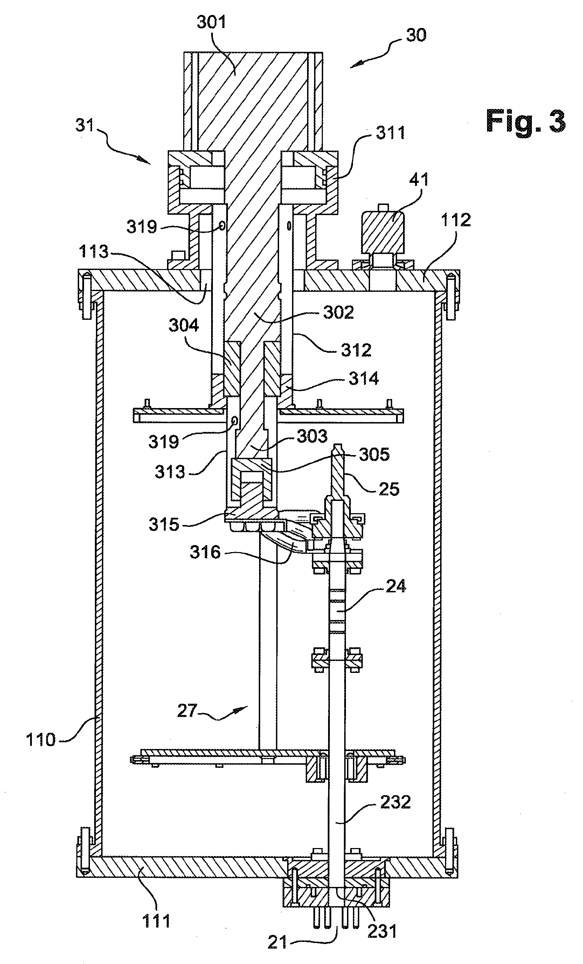

- figure 3: une coupe de l'amplificateur dans un plan radial passant par l'axe du guide d'onde du coupleur d'entrée ;

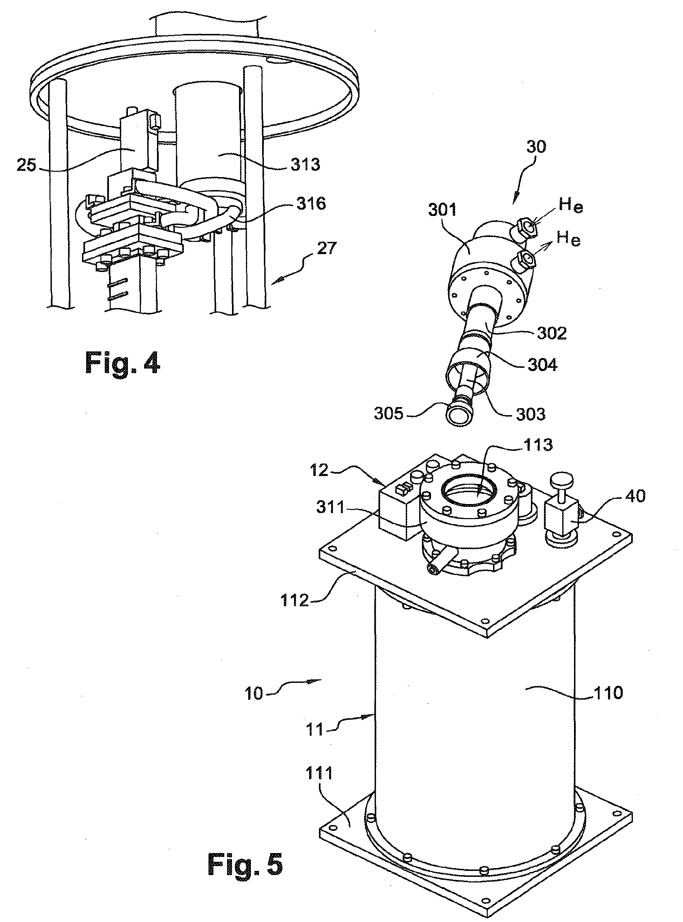

- figure 4: une vue partielle agrandie en perspective montrant le couplage thermique de l'amplificateur faible bruit avec la tête froide ;
- figure 5: une vue en perspective de l'amplificateur et de la tête froide extraite de l'amplificateur.

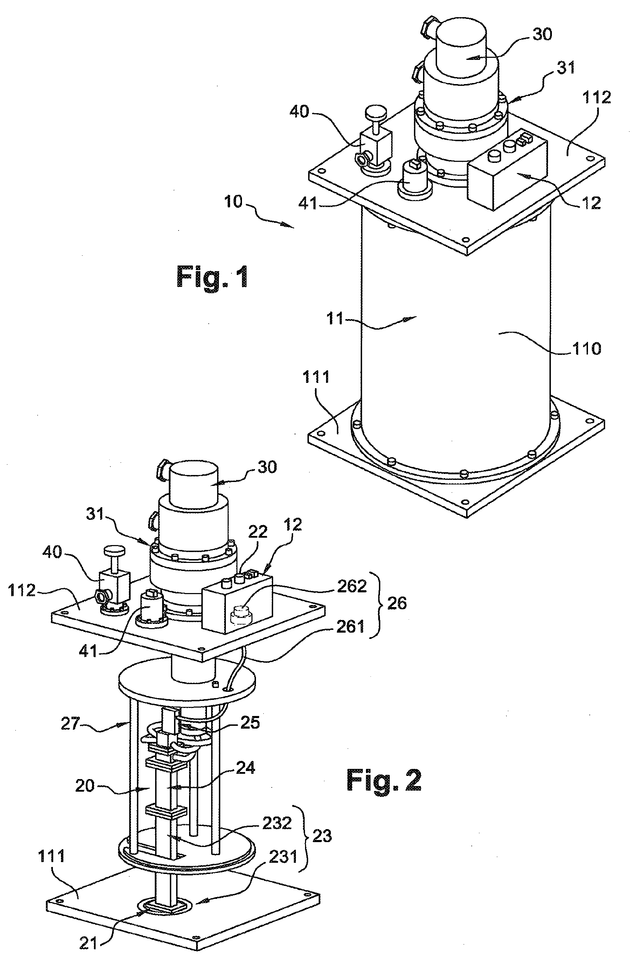

Comme représenté sur la figure 1 un amplificateur cryogénique 10 suivant l'invention comporte une enveloppe 11 renfermant, dans un volume intérieur de ladite enveloppe, un ensemble de composants radiofréquences destiné à amplifier le signal reçu par une antenne, non représentée.

L'amplificateur considéré est destiné à amplifier des signaux hautes fréquences, de plusieurs centaines de mégahertz et jusqu'à plusieurs centaines de gigahertz.

L'enveloppe 11 est constituée principalement d'une enveloppe latérale 110 de forme cylindrique et de deux plateaux de base, un plateau de base supérieur 111 et un plateau de base inférieur 112.

L'enveloppe 11 est réalisée de manière étanche et suffisamment rigide pour résister à une pression s'exerçant depuis un espace extérieur de l'enveloppe vers l'intérieur de l'enveloppe de l'ordre de 10E5 Pa, c'est à dire sensiblement la pression atmosphérique.

Afin de répondre aux exigences de sensibilité et de rapport signal sur bruit pour la réception de signaux de très faibles puissances émis par des émetteurs lointains, tels que des sondes interplanétaires distantes de plusieurs centaines de millions de kilomètres, l'amplificateur est refroidi à des températures cryogénique, par exemple inférieures à vingt Kelvins, pour diminuer le bruit d'origine thermique des composants électroniques de l'amplificateur.

Un refroidissement à très basse température est nécessaire pour les applications considérées compte tenu de la modestie des amplificateurs embarqués sur les sondes interplanétaires, généralement quelques dizaines de Watts, et la distance séparant ces sondes au cours de leurs voyages qui amènent les signaux reçus pour lesquels il est espéré retirer un signal utilisable à des énergies pouvant être aussi faibles que 10E-15 Watt voire inférieures.

Comme visible sur la figure 2 de l'amplificateur cryogénique 10 assemblé et représenté sans l'enveloppe latérale 110, l'amplificateur cryogénique 10 comporte une chaîne d'amplification radiofréquence 20, laquelle chaîne d'amplification comporte depuis une entrée 21 de l'amplificateur vers une sortie 22 de l'amplificateur :
- un coupleur d'entrée 23, comportant dans le cas illustré :
   - une fenêtre guide d'onde 231 ;
   - un guide d'onde 232 ;
- un filtre radiofréquences 24 ;
- un amplificateur faible bruit 25 ;
- un coupleur de sortie 26, comportant dans le cas illustré :
   - un câble coaxial 261 ;
   - un connecteur coaxial 262 étanche.

L'amplificateur cryogénique 10 comporte également une tête froide 30 traversant le plateau de base inférieur 112 et montée de sorte à préserver l'étanchéité de l'espace intérieur de l'enveloppe 11.

Suivant l'invention, l'agencement de ces différents composants de la chaîne d'amplification radiofréquences 20 dans l'enveloppe 11 ainsi que de la structure de ladite enveloppe sont réalisés pour minimiser les pertes thermiques, c'est à dire minimiser un flux de chaleur de l'extérieur vers l'intérieur de l'enveloppe 11, et pour permettre de maintenir la température cryogénique attendue inférieure à vingt Kelvins au niveau de l'amplificateur faible bruit 25, mais cependant sans que les nécessaires opérations de maintenance ne pénalisent la disponibilité opérationnelle de l'amplificateur.

L'enveloppe 11 est une enceinte étanche et isolante sur le plan thermique qui forme un cryostat, ou Dewar, à l'intérieur duquel est enfermé la chaîne d'amplification 20 dont l'amplificateur faible bruit 25 est maintenu à une température cryogénique inférieure à 20 Kelvins.

Pour assurer l'étanchéité de l'enveloppe 11, des moyens conventionnels sont mis en oeuvre entre les éléments principaux de ladite enveloppe, c'est à dire l'enveloppe latérale 110 et les plateaux de bases supérieur 111 et inférieur 112 qui sont assemblés avec l'interposition de joints d'étanchéité à leurs interfaces.

L'étanchéité de l'enveloppe 11 est également assurée au niveau de l'entrée 21 et de la sortie 22 de l'amplificateur 10.

Pour l'entrée 21 de l'amplificateur, l'étanchéité est assurée par une fenêtre guide d'onde 231 au niveau d'une traversée du plateau de base inférieur 111 par le guide d'onde 232 du coupleur d'entrée 23.

La fenêtre guide d'onde 231 est réalisée au niveau d'une ouverture du plateau de base inférieure 111 fermée par une feuille mince d'un matériau diélectrique, transparent aux ondes radio dans le domaine des fréquences reçues, cette feuille étant maintenue de manière étanche par rapport au plateau de base inférieure entre deux brides. L'étanchéité est assurée d'une part entre les brides et la feuille mince par un joint torique et d'autre part entre la fenêtre guide d'onde 231 ainsi constituée et le plateau de base inférieur 111 par un autre joint torique.

Pour la sortie 22 de l'amplificateur, l'étanchéité est assurée par le connecteur coaxial étanche 262, qualifié au vide, du coupleur de sortie 26 à câble coaxial, ledit connecteur coaxial étant également monté de manière étanche sur le plateau de base inférieur 112.

Pour assurer le passage de signaux continus à travers l'enveloppe 11 tels que l'alimentation électrique de l'amplificateur et d'éventuels capteurs de l'amplificateur, des traversées électriques étanches sont également prévues, avantageusement regroupées à proximité du connecteur coaxial étanche 262 au niveau d'un boîtier de raccordement électrique 12 fixé sur le plateau de base inférieur, boîtier qui protège les connecteurs étanches montés sur le plateau de base inférieur 112 et qui regroupe éventuellement des composants de l'amplificateur n'ayant pas besoin d'être refroidis à la température cryogénique.

L'étanchéité de l'enveloppe doit également être assurée au niveau de la tête froide 30 devant porter et maintenir la température de l'amplificateur faible bruit 25 en dessous de 20 Kelvins, ladite tête froide traversant l'enveloppe 11 au niveau du plateau de base inférieur par une ouverture 113 afin d'être raccordée à un compresseur d'Hélium avec des lignes pressurisées.

La manière dont l'étanchéité est réalisée dans le cas de la traversée de la tête froide est détaillée ultérieurement avec le fonctionnement de ladite tête froide.

Pour atteindre la température cryogénique souhaitée, il est indispensable de limiter les transferts de chaleur entre l'intérieur de l'enveloppe 11 et l'extérieur à température ambiante faute de quoi la température voulue pour l'amplificateur faible bruit ne pourrait pas être atteinte sans faire appel à une tête froide surdimensionnée.

Les transferts de chaleur se produisent sous les différentes formes connues par conduction, par convection et par rayonnement et la conception de l'amplificateur 10 limite les transferts de chaleur sous ces différentes formes sans qu'il soit fait appel à un vide poussé généralement mis en oeuvre dans les situations équivalentes.

Un vide poussé, aussi appelé vide secondaire, correspond à des pressions inférieures à un microbar (0,1 Pa) et est généralement utilisé comme moyen d'isolation thermique efficace pour contraindre les échanges de chaleur de convection et de conduction. Toutefois le vide poussé est difficile à obtenir et à maintenir, en particulier dans les enceintes de petites dimensions, en raison du dégazage des matériaux dans le milieu à vide poussé, et le vide poussé doit être régulièrement maintenu et doit en général être recréé après un retour à la température ambiante, par le moyen de pompes turbomoléculaires complexes et coûteuses.

En outre pour contrer les apports de chaleur par rayonnement il est nécessaire d'adjoindre dans ce cas des écrans anti-radiatifs qui occultent les rayonnements infrarouges.

L'agencement de l'enveloppe 11 tel qu'il vient d'être décrit convient à l'établissement d'un vide poussé à l'intérieur de l'enveloppe.

Toutefois l'architecture de l'amplificateur 10 est telle que les échanges de chaleur avec l'extérieur sont minimisés afin de garantir que la température de l'amplificateur faible bruit 25 est inférieure à vingt Kelvins sans qu'il soit nécessaire de réaliser un vide poussé dans l'enveloppe 11.

Ce résultat est obtenu en concentrant le refroidissement sur un support de l'amplificateur faible bruit 25 et en isolant ledit support et l'amplificateur des sources pouvant lui apporter de la chaleur.

Afin de limiter les apports de chaleur par conduction, les coupleurs d'entrée 23 et de sortie 26 de l'amplificateur à l'intérieur de l'enveloppe 11, qui par nécessité réalise une continuité physique entre l'amplificateur faible bruit 25 et l'enveloppe 11 qui l'isole de l'environnement extérieur, sont réalisés avec des matériaux faiblement conducteur de la chaleur.

Dans l'exemple de réalisation illustré sur les figures, le coupleur d'entrée 23 comporte le guide d'onde 232 qui reçoit le signal radiofréquences par la fenêtre de guide d'ondes 231 pour guider le signal vers l'amplificateur faible bruit 25 à l'intérieur de l'enveloppe 11, le cas échéant après avoir traversé un filtre 24.

Les guides d'ondes permettent la réalisation de coupleur d'entrée de bonnes performances sur le plan du couplage radioélectrique, mais doivent être réalisés avec des matériaux très bons conducteurs électriques qui sont également en pratique des matériaux qui conduisent bien la chaleur donc sont incompatibles avec l'amplificateur de l'invention.

Pour résoudre cette difficulté, le guide d'onde 232 est réalisé avec un matériau ayant des caractéristiques de mauvaise conduction thermique c'est à dire de conductivité thermique au moins inférieure à 50 W/m.K.

Avantageusement le guide d'onde 232 est réalisé dans un matériaux métallique tel qu'un acier inoxydable dont la conductivité thermique est de l'ordre de 16 W/m.K ou un alliage Fer-Nickel à forte teneur en nickel type INVAR®, comportant environ 36% de Nickel, dont la conductivité thermique est de l'ordre de 13 W/m.K, valeurs à comparer à celles de l'aluminium ou du cuivre respectivement de l'ordre de 200 et 350 W/m.K, soit des conductivités thermiques environ vingt fois plus faibles.

D'autres matériaux, non métalliques, sont également avantageusement utilisés dont les conductivités thermiques peuvent êtres très inférieures aux valeurs des matériaux métalliques citées ci-dessus. Ainsi il est possible d'utiliser des matériaux du domaine des céramiques ou des matériaux composites comportant des fibres, par exemple des fibres de carbone, maintenues dans une résine durcie dans la mesure où le matériau sélectionné est apte à résister aux températures cryogéniques de fonctionnement de l'amplificateur.

Le choix d'un acier inoxydable ou d'un alliage type INVAR® à faible conductivité thermique conduit à sélectionner un matériau du guide d'onde ayant une conductivité électrique faible de l'ordre de un 10E6 Siemens/m, et le choix d'un matériau céramique ou composite conduit généralement à une conductivité électrique encore plus faible, ces derniers matériaux étant le plus souvent mauvais conducteurs électriques sinon considérés comme isolants électriques. Ces choix sont donc contraires à l'obtention de bonnes performances d'un guide d'onde et à la continuité électrique entre l'entrée 21 de l'amplificateur et l'amplificateur faible bruit 25.

Pour palier à cette contrainte électrique du choix d'un matériau à faible conduction thermique, un dépôt mince d'un matériau à forte conductivité électrique, supérieure à 10E7 Siemens/m, recouvre la surface d'une paroi interne (non visible sur les figures) du guide d'onde 232.

Un tel matériau est par exemple de l'argent Ag, de conductivité électrique 62 10E6 Siemens/m, du cuivre Cu, de conductivité électrique 58 10E6 Siemens/m, ou encore de l'or Au, de conductivité électrique 44 10E6 Siemens/m, ou un alliage comportant ces matériaux, dont les conductivités électriques sont donc au moins 40 à 60 fois plus élevées que celle du matériau choisi pour former la structure du guide d'onde, et qui est déposée sur la surface interne des parois du guide d'onde sous la forme d'une couche mince la plus fine possible permise par la technologie de dépôt utilisée et compte tenu des fréquences des signaux devant être amplifiées, par exemple par dépôt électrolytique, de préférence inférieur en une couche d'épaisseur inférieure à cinq micromètres voire de l'ordre du micromètre ou moins si de telles épaisseurs sont suffisantes compte tenu des fréquences des signaux guidés pour en assurer la propagation, sur le matériau à faible conductivité thermique.

Ces principes appliqués au guide d'onde 232 pour diminuer les pertes thermiques par conduction sans perdre en performance radioélectrique du guide d'onde sont également appliqués au filtre 24 et aux autres éléments éventuellement intercalés entre l'entrée 21 de l'amplificateur et l'amplificateur faible bruit 25 ce qui permet d'augmenter encore la résistance thermique résultante entre ledit amplificateur et l'entrée 21.

Dans l'exemple de réalisation illustré sur les figures, le coupleur de sortie 22 comporte un câble coaxial 261 qui transmet à l'intérieur de l'enveloppe 11 le signal amplifié depuis l'amplificateur faible bruit 25 vers le connecteur étanche 262.

Comme dans le cas du guide d'ondes 232 du coupleur d'entrée 23, le câble coaxial est réalisé pour augmenter au maximum sa résistance thermique sans affecter significativement ses performances électriques aux fréquences mises en jeux. Ainsi le cuivre très généralement utilisé pour les parties conductrices des câbles coaxiaux est dans le cas de l'amplificateur de l'invention délaissé au profit de matériaux ayant une mauvaise conductivité thermique.

Dans le cas du câble coaxial 261 ont utilise avantageusement un acier inoxydable qui présente en outre de sa mauvaise conductivité thermique des caractéristiques de malléabilité permettant de lui appliquer des procédés de tréfilage et de réaliser des fils avec plusieurs brins ou des nappes tissées.

Le câble coaxial 261 comporte de manière conventionnelle un conducteur central, un diélectrique enveloppant le conducteur central et une gaine extérieure conductrice ou blindage.

La gaine extérieure est en acier inoxydable, par exemple tissée en fils d'acier.

Le diélectrique est un polymère de type PolyTétraFluoroEthylène dit PTFE.

Le conducteur central est également réalisé par un fil en acier inoxydable comportant de préférence un seul brin plaqué avec un métal bon conducteur de l'électricité tel que de l'argent, du cuivre ou de l'or en une couche mince micronique ou submicronique comme dans le cas de la paroi intérieur du guide d'ondes 231.

Outres les considérations thermiques exposées précédemment sur la réduction des transmissions de chaleur par conduction au niveau des coupleurs d'entrée et de sortie, l'enveloppe 11 du cryostat est remplie d'un matériau isolant thermique qui, associé à un vide peu poussé ou vide primaire réalisé à la température ambiante avant la mise en service de l'amplificateur, isole la partie de la chaîne d'amplification 20, en particulier l'amplificateur faible bruit 25, devant être maintenue à la température cryogénique la plus faible possible.

Le matériau isolant est un matériau à faible densité et à l'état solide. Dans sa forme préférée, il s'agit d'un matériau nanostructuré à faible densité tel qu'un matériau nanostructuré réalisé à base de silice SiO2.

Un tel matériau isolant est disponible sous la forme d'un aérogel de silice qui est diffusé commercialement sous forme de microbilles ou de feuilles pouvant être déposées en couches. La cavité est par exemple remplie en microbilles par un orifice, non visible sur les dessins, sur une face de l'enveloppe étanche, orifice fermé par un bouchon étanche en conditions opérationnelles.

En outre la réalisation d'un vide peu poussé à l'intérieur de l'enveloppe 11 du cryostat, c'est à dire correspondant à une pression comprise entre la pression ambiante et 0,1millibar (10 Pa), c'est-à-dire une pression supérieure à 100 fois la pression d'un vide poussé, pression qui sera encore abaissée naturellement sous le simple effet de la diminution de la température par le phénomène connu sous le nom de pompage cryogénique, s'avère bénéfique en diminuant sensiblement les pertes d'énergie thermique mais sans exiger, lorsque la température est à nouveau abaissée après que la température à l'intérieur de l'enveloppe 11 du cryostat a été élevée jusqu'à la température ambiante par exemple suite à un arrêt de l'amplificateur 10, de réaliser à nouveau le vide.

Un tel vide peu poussé est réalisé sans difficulté particulière au moyen d'une pompe d'aspiration à vide primaire, pompe mécanique conventionnelle, contrairement aux vides poussés qui exigent en plus de la pompe à vide primaire de mettre en oeuvre une pompe turbomoléculaire coûteuse et contraignante, et qui serait de surcroît nécessaire même sans ouverture de l'enceinte cryogénique en cas de retour de l'amplificateur à une température non cryogénique si un vide poussé devait être maintenu dans l'enveloppe 11 du cryostat.

Pour tirer parti de cet avantage, l'enveloppe 11 du cryostat comporte une valve 40 pourvue d'une prise d'aspiration sur laquelle est raccordée la pompe à vide peu poussé lorsque le vide a été rompu, ce qui est avantageusement détecté par un indicateur de vide 41 fixé sur l'enveloppe 11.

Pour assurer le refroidissement des composants de l'amplificateur à l'intérieur du cryostat, la tête froide 30 comporte plusieurs étages de froid, au moins deux comme dans l'exemple illustré sur les figures.

Un premier étage a sa température abaissée à une température intermédiaire entre la température recherchée et la température ambiante, par exemple 50 K, et un deuxième étage à sa température encore abaissée par rapport au premier étage pour atteindre la température recherchée, par exemple 15 K.

La tête froide 30 utilise une compression détente d'hélium en circuit fermé suivant un cycle de Gifford-Mac Mahon pour pomper la chaleur.

Le principe générale d'une tête froide à plusieurs étages fonctionnant suivant ce principe est connu dans le domaine de la liquéfaction des gaz et des matériaux supraconducteurs mis en oeuvre dans les bobines magnétiques qui nécessitent d'être refroidis à des températures proches de zéro K et ne sera pas détaillé ici. La demande de brevet publiée sous le numéro GB 2420611 fournit un exemple de tête froide à trois étages suivant ce principe.

Ces types de têtes froides permettent d'atteindre les températures très basses recherchées et utilisent des parties mécaniques en mouvement incorporées dans la tête dont le fonctionnement est source d'usure et de pannes potentielles.

De préférence la tête froide est assemblée depuis l'extérieur de l'enceinte sans qu'il soit nécessaire d'ouvrir l'enceinte 11.

Dans un mode préféré de réalisation la tête froide 30 comporte un premier étage 302, ou étage intermédiaire, portant une terminaison froide intermédiaire 304 et un deuxième étage 303, ou étage terminal, portant une terminaison froide d'extrémité 305, les dits premier et deuxième étages ayant des formes sensiblement cylindriques formant la tête froide interne.

La tête froide interne est logée dans une douille 31, formant un fourreau 312, 313 pour les premier et deuxième étages de la tête, qui est fixée à l'enveloppe 11 du cryostat, dans l'exemple illustré au plateau de base inférieur 112, de manière étanche au niveau d'une ouverture 113 de ladite enveloppe de sorte que la tête froide peut être démontée et remontée sans qu'il soit nécessaire de démonter ladite douille.

Ainsi la partie intérieure de la tête froide 30 peut être introduite ou sortie de l'intérieur du cryostat sans ouvrir le cryostat et donc sans risquer d'endommager les éléments d'étanchéité de l'enceinte ni les composants enfermés dans l'enceinte, ladite partie intérieure étant toujours confinée dans l'enceinte 11 et protégés par la douille 31.

Le volume intérieur de la douille 31 est en relation avec le volume intérieur du cryostat par le moyen de lumières 319, ouvertures de petites dimensions aménagées dans la paroi de la douille, de sorte que la pression dans la douille interne est diminuée comme la pression interne du cryostat ce qui limite des pertes par convection et par conduction entre le volume intérieur de la douille interne ou se trouve les étages refroidis de la tête froide et l'air extérieur. En conséquence la tête froide 30 est également fixée de manière étanche par rapport à la douille (31).

Pour assurer le pompage thermique de la chaleur, l'étage terminal 303, plus précisément une terminaison froide terminale 315 dudit étage terminal, est relié par des liens thermiques 315, 316 à l'amplificateur faible bruit 25 qui doit être le composant de l'amplificateur porté à la température la plus basse. Les liens thermiques sont des ponts réalisés au moyen de matériaux inertes bons conducteurs de la chaleur comme par exemple du cuivre.

En outre le pompage thermique est également assuré par l'étage intermédiaire 302, plus précisément par une terminaison froide intermédiaire 314 dudit étage intermédiaire, reliée directement ou indirectement par des liens thermiques 314 à des éléments internes tels que des composants secondaires de l'amplificateur : guide d'onde 232, filtre 24, câble coaxial 261... n'exigeant pas d'être refroidi à aussi basse température que l'amplificateur faible bruit, et tels que des structures internes 27 du cryostat destinées à assurer le support des différents composants ce qui permet de réaliser un pompage réparti de la chaleur interne du cryostat.

Pour permettre le pompage de la chaleur vers les terminaisons froides de la tête froide tout en autorisant le démontage de la tête froide 30 et son extraction de la douille 31 sans ouvrir l'enceinte 11 du cryostat, chaque terminaison froide terminale 305 et intermédiaire 304 est, lorsque la tête froide est montée et la température de fonctionnement de l'amplificateur établie, en contact intime avec un lien thermique 314, respectivement 315, solidaires de la douille 31 et lui-même en liaison thermique directement ou indirectement avec les éléments internes de l'amplificateur devant être refroidis. Le contact intime est ici pris en considération en regard de la résistance thermique aussi réduite que possible permettant la conduction du flux de la chaleur devant être extraite, c'est à dire avec une surface de contact physique suffisante et une pression de contact également suffisante, qui peut être assuré par serrage à froid, pour assurer le contact intime nécessaire sans toutefois que la terminaison froide ne soit fixée au lien thermique correspondant.

Ainsi, au moins lorsque la température de l'amplificateur est amenée à la température ambiante, la tête froide peut être extraite de la douille.

Un exemple d'un tel assemblage d'une tête cryogénique dans un cryostat par l'intermédiaire d'une douille est décrit de manière détaillée dans le brevet US 5235818 ou encore dans le brevet US 5934082.

Lorsque l'amplificateur 10 est en fonctionnement, l'ensemble des composants dont l'amplificateur faible bruit 25 et les coupleurs d'entrée 23 et de sortie 26 sont fixés à l'intérieur de l'enceinte étanche 11 du cryostat, enceinte remplie d'un isolant thermique tel qu'un aérogel et dans laquelle un vide peu poussé a préalablement été réalisé, et la tête froide 30 fonctionne pour délivrer une température de l'ordre de 50K au niveau de la terminaison froide intermédiaire 304 de l'étage intermédiaire 302 et une température de l'ordre de 15K au niveau de la terminaison froide d'extrémité 305 de l'étage terminal 303.

En régime établi du fonctionnement de l'amplificateur 10, l'étage intermédiaire de la tête froide assure, avec la participations des structures de soutien 27 qui sont liées thermiquement à l'extrémité froide 304 de l'étage intermédiaire 302 par le lien thermique intermédiaire 314, un pompage général de la chaleur qui est générée dans le cryostat par le fonctionnement de l'amplificateur où qui pénètre depuis l'extérieur vers l'intérieur du cryostat du fait d'imperfections d'isolation par conduction et convection résiduelle liée à l'absence de vide poussé, et malgré le remplissage par l'aérogel ainsi que par rayonnement thermique des parois de l'enceinte du cryostat et de l'amplificateur faible bruit 25.

Dans l'enceinte du cryostat ainsi refroidie à une température intermédiaire relativement base mais insuffisante pour obtenir la réduction des bruits thermiques recherchée, l'amplificateur faible bruit 25 est refroidi et maintenu à la température voulue pour cet amplificateur par le pompage thermique de l'étage terminal 303 de la tête froide à laquelle il est relié par les liens thermiques 315 et 316. Du fait de la résistance thermique élevée des coupleurs d'entrée 23 et de sortie 26 obtenue par la structure adaptée desdits coupleurs dans des conditions qui préservent la qualité de transmission des signaux à amplifier ou amplifiés, la température de l'amplificateur faible bruit 25 est abaissée pratiquement à la température pouvant être atteinte par l'étage terminal 303 de la tête froide 30.

Lorsque la température de l'amplificateur 10 est élevée jusqu'à la température ambiante donc aux environs de 290K, suite en particulier à un arrêt voulu ou non voulu du fonctionnement de la tête froide, il est en général possible, aussi longtemps que l'enceinte du cryostat n'a pas été mise à l'air libre, de remettre en service l'amplificateur sans refaire le vide peu poussé dans l'enceinte du cryostat lorsque la tête froide est à nouveau en fonctionnement.

En effet le vide peu poussé n'est pas cassé du fait d'un simple retour à la température ambiante alors qu'un vide poussé se trouve détruit lors d'un tel retour à température ambiante en particulier par le dégazage des matériaux dans l'enceinte du cryostat.

Si une réparation, un remplacement ou une opération d'entretien doit être effectuée sur la tête froide 301 qui nécessite de démonter la tête froide, le vide peu poussé est nécessairement détruit mais l'enceinte 11 du cryostat n'est pas ouverte et la tête froide est extraite de la douille 31 en démontant la dite tête froide par une partie extérieure 311 de la douille sans forcer sur les partie internes. Du fait de la partie intérieure de la douille 312, 313 les éléments à l'intérieur du cryostat sont mécaniquement protégés et ne peuvent pas être endommagés par ce démontage ni par le remontage de la tête froide et l'aérogel remplissant l'enceinte 11 n'a pas besoin d'être vidé.

Lorsque que la tête froide, ou une nouvelle tête froide, a été remontée et fixée à la douille de manière étanche, l'enceinte du cryostat est à nouveau étanche et le vide peut être réalisé en raccordant une pompe mécanique pour vide peu poussé à la valve 40, l'indicateur 41 fixé à demeure sur l'enceinte 11 donnant le cas échéant une information sur la valeur de la pression dans ladite enceinte lorsque l'amplificateur est en fonction.

Lorsque ce vide peut poussé est réalisé, la tête froide peut être remise en fonctionnement pour abaisser la température à l'intérieur du cryostat ainsi que la pression par le phénomène de cryopompage et enfin de l'amplificateur faible bruit 25.

L'amplificateur de l'invention dont un exemple de réalisation vient d'être décrit de manière détaillée peut comporter diverses variantes à la portée de l'homme du métier au vus des enseignements qui viennent d'être donnés.

En ce qui concerne les coupleurs d'entrée et de sortie de l'amplificateur les détails de réalisation du coupleur à guide d'ondes décrit dans le cas du coupleur d'entrée peuvent être parfaitement mis en oeuvre pour réaliser un coupleur de sortie à guide d'ondes en lieu et place du coupleur à câble coaxial décrit.

Réciproquement le coupleur d'entrée peut être réalisé au moyen d'un câble coaxial ayant une structure similaire à celle du coupleur à câble coaxial décrit dans le cas d'un coupleur de sortie.

En pratique le choix de coupleurs à guide d'ondes ou à câble coaxial sera réalisé en fonction de performances attendues de l'amplificateur et de critères de coûts qui vont dépendre des fréquences des signaux devant être amplifiés.

En particulier dans les signaux de fréquences inférieures à environ 3GHz, les pertes d'insertion des câbles coaxiaux peuvent être suffisamment faibles pour être tolérées.

En ce qui concerne la tête froide on comprend que celle-ci peut comporter deux ou plus étages intermédiaires mais dans la pratique les performances thermiques obtenues avec l'amplificateur dont les caractéristiques de structure viennent d'être décrites ont démontré qu'une tête froide à deux étages est le plus souvent suffisante pour faire fonctionner l'amplificateur à une température voisine de 15K, et la complexité d'une tête froide comportant plus de deux étages ne se justifie a priori que dans le cas d'un amplificateur dont la température en fonctionnement devrait être descendue en dessous de 10K ou avec une puissance telle qu'il serait nécessaire de pomper plus de chaleur de l'amplificateur faible bruit.

Pour assurer des fonctions complémentaires de l'amplificateur ou pour atteindre des performances particulières, d'autres composants peuvent être agencés dans l'enceinte du cryostat tels que :
- des composants radiofréquences pour améliorer la réjection des signaux hors de la bande passante par des filtres passe bande ou passe bas fonctionnant à température cryogénique ;
- un isolateur fonctionnant à température cryogénique pour améliorer le coefficient de réflexion à l'entrée du cryostat, en particulier en raison des performances souvent médiocres des amplificateurs faible bruit au niveau du coefficient de réflexion d'entrée, et si besoin un isolateur cryogénique en sortie de l'amplificateur pour corriger un coefficient de réflexion trop important ;
- un coupleur hyperfréquence pour injecter un signal de test dans le cryostat.

Ces différents composants sont sur le plan fonctionnel de même nature que les composants déjà décrits dans la description détaillée et ils doivent être traités de manière similaire tant dans leurs structures que dans leurs montages et leurs liaisons thermiques à l'intérieur de l'enceinte 11 de l'amplificateur.

D'autres composants peuvent le cas échéant être associé à l'amplificateur pour des raisons de proximité et d'intégration sans être nécessairement placé dans les conditions de froid à l'intérieur de l'enceinte 11 comme par exemple un boîtier de post-amplification à faible bruit permettant d'atteindre un gain d'amplification global recherché par l'amplificateur 10, le signal ayant été préamplifié par l'amplificateur faible bruit refroidi à température cryogénique étant alors moins sensible au bruit thermique.

Pour tirer pleinement parti des avantages de l'amplificateur suivant l'invention en matière de maintenance préventive ou corrective, avantageusement un système de réchauffage, par exemple des résistances électriques, est disposé à l'intérieur de l'enceinte 11 du cryostat.

Lorsque l'amplificateur est arrêté pour une intervention, après que la tête froide a été arrêtée, le système de réchauffage est mis en service pour ramener la température interne du cryostat à une valeur proche de la température ambiante.

Le réchauffement est nécessaire d'une part pour permettre le démontage de la tête froide lorsque les bagues de serrage à froid sont à une température suffisamment élevée et également pour éviter la formation de condensation d'eau à l'intérieur de l'enceinte lors de la rupture du vide peu poussé.

En pratique les performances thermiques obtenues dans l'amplificateur de l'invention sont telles que l'utilisation du système de réchauffage permet de réduire de deux jours à sept heures le temps total pendant lequel l'amplificateur est immobilisé pour remplacer la tête froide.

L'amplificateur de l'invention s'avère donc particulièrement performant sur le plan opérationnel en ayant un niveau d'exigences beaucoup plus faible en matière de qualité du vide dans l'enceinte du cryostat et du fait de l'optimisation des flux thermiques en termes de puissance thermique installée et en diminuant de l'ordre de 7 fois le temps d'immobilisation pour une opération essentiel de remplacement de la tête froide par rapport à une technologie conventionnelle.

## Revendications

1. Amplificateur radiofréquences (10) pour dispositif de réception d'un signal radiofréquence de faible puissance comportant un amplificateur faible bruit (25) maintenu dans un espace hermétique délimité par une enceinte (11) d'un cryostat dans lequel espace est maintenue une pression intérieure réduite par rapport à une pression atmosphérique extérieure, ledit amplificateur faible bruit recevant des signaux à amplifier d'un coupleur d'entrée (23) traversant l'enceinte (11) de manière étanche et transmettant les signaux amplifiés par un coupleur de sortie (26) traversant l'enceinte (11) de manière étanche, ledit espace étant refroidi au moyen d'une tête froide (30) de pompage de la chaleur à l'intérieur de l'enceinte (11) **caractérisé en ce que** dans l'amplificateur radiofréquence (10) :
- les coupleurs d'entrée (23) et de sortie (26) sont réalisés pour une partie structurale avec un matériau de conductivité thermique égale ou inférieure à 50W/m.K et pour une partie électriquement conductrice par un plaquage sur ladite partie structurale d'un matériau de conductivité électrique supérieure à 10E7 Siemens/m ;
- la pression intérieure dans l'enceinte (11) du cryostat correspond avant la diminution de la température à une pression d'un vide peu poussé ou vide primaire comprise entre la pression atmosphérique et 10 Pa ;
- l'espace hermétique délimité par l'enceinte (11) est remplie d'un matériau isolant thermique nanostructuré à base de silice sous forme d'un aérogel ;
- la tête froide (30) comporte au moins deux étages (302, 303) dont des terminaisons froides (304, 305) sont à des températures cryogéniques différentes, un étage terminal (305) fonctionnant à une température proche de la température à laquelle l'amplificateur faible bruit (25) doit fonctionner et au moins un étage intermédiaire fonctionnant à une température intermédiaire entre la température de l'étage terminal et une température ambiante, une terminaison froide terminale (315) de l'étage terminal (305) étant thermiquement reliée (315, 316) à l'amplificateur faible bruit (25) de sorte à réaliser un pompage de la chaleur dudit amplificateur faible bruit et une terminaison froide intermédiaire (304) dudit au moins un étage intermédiaire (302) étant thermiquement reliée (314) à des structures support (27) ou des éléments internes de l'amplificateur (10) de sorte à réaliser un pompage de la chaleur diffuse à l'intérieur de l'enceinte (11).

2. Amplificateur radiofréquences suivant la revendication 1 dans lequel le coupleur d'entrée (23), et ou le coupleur de sortie, comporte un guide d'onde (232) traversant de manière étanche une paroi de l'enceinte (11) du cryostat au niveau d'une fenêtre guide d'ondes (231), ledit guide d'onde comportant des parois dont la structure est réalisée avec le matériau à conductivité thermique égale ou inférieure à 50W/m.K et dont une surface interne dudit guide d'onde est recouverte du plaquage du matériau de conductivité électrique supérieure à 10E7 Siemens/m.

3. Amplificateur radiofréquences suivant la revendication 1 dans lequel le coupleur de sortie (26), et ou le coupleur d'entrée, comporte un câble coaxial (261) traversant de manière étanche une paroi de l'enceinte (11) du cryostat au niveau d'une prise coaxiale (262), ledit câble coaxial comportant un conducteur central réalisée avec le matériau à conductivité thermique égale ou inférieure à 50W/m.K et dont une surface externe dudit conducteur central est recouverte du plaquage du matériau de conductivité électrique supérieure à 10E7 Siemens/m et le dit câble coaxial comportant une tresse de blindage réalisée dans un matériau métallique à conductivité thermique égale ou inférieure à 50W/m.K.

4. Amplificateur radiofréquences suivant la revendication 2 ou suivant la revendication 3 dans lequel le matériau à conductivité thermique égale ou inférieure à 50W/m.K est un matériau métallique appartenant à la famille des aciers inoxydables ou des alliages fer-nickel comportant environ 36% de nickel ou un matériau céramique ou un matériau composite comportant des fibres maintenues dans une résine durcie.

5. Amplificateur radiofréquences suivant la revendication 4 dans lequel le matériau de conductivité électrique supérieure à 10E7 Siemens/m appartient à la famille des métaux ou alliages métalliques comportant de l'argent Ag, de l'or Au ou du cuivre Cu.

6. Amplificateur radiofréquences suivant l'une des revendications précédentes dans lequel la tête froide (30) est fixée à l'enceinte (11) du cryostat depuis l'extérieur dudit cryostat par l'intermédiaire d'une douille (31) solidaire de manière étanche de ladite enceinte.

7. Amplificateur radiofréquences suivant la revendication 6 dans lequel la douille (31) comporte une douille interne (312, 313) formant un fourreau traversant l'enceinte (11) au niveau d'une ouverture (113) dans lequel sont maintenus les étages intermédiaires (302) et terminal (303) de la tête froide (30), des terminaisons froides (304, 305) de ladite tête froide étant, directement ou indirectement, en continuités thermiques avec des éléments internes (232, 24, 25, 261, 27) de l'amplificateur par l'intermédiaire de liens thermiques (314, 315) solidaire de la douille (31).

8. Amplificateur radiofréquences suivant la revendication 7 dans lequel la continuité thermique entre une terminaison froide (304, 305) de la tête froide (30) un lien thermique (314, 315) lui correspondant solidaire de la douille (31) est assuré par contact ou serrage lorsque la température est abaissée et sans serrage lorsque la température de l'amplificateur est proche de la température ambiante.

9. Amplificateur radiofréquences suivant la revendication 8 dans lequel la douille interne (312, 313) comporte des lumières (319) de communication entre un volume intérieur du fourreau formé par ladite douille interne et le volume intérieur de l'enceinte du cryostat.

10. Amplificateur radiofréquences suivant l'une des revendications précédentes dans lequel des composants accessoires de la chaîne d'amplification sont agencés dans le cryostat pour être maintenus à température cryogénique, lesdits composants accessoires appartenant à l'une des catégorie des filtres (24) agissants sur la bande passante des signaux, des isolateurs agissant sur les réflexions des signaux, des coupleurs de signaux.

11. Amplificateur radiofréquences suivant l'une des revendications précédentes dans lequel un système de réchauffage du dit amplificateur radiofréquences est agencé à l'intérieur de l'enceinte (11) du cryostat.

## Patentansprüche

1. Funkfrequenzverstärker (10) für eine Empfangsvorrichtung eines Funkfrequenzsignals von geringer Stärke, umfassend einen rauscharmen Verstärker (25), der in einem hermetisch dichten Raum gehalten wird, der von einem Kryostatbehälter (11) begrenzt ist, in welchem Raum ein verringerter Innendruck in Bezug auf einen äußeren Luftdruck aufrechterhalten wird, wobei der rauscharme Verstärker zu verstärkende Signale von einem Eingangskoppler (23) empfängt, der den Behälter (11) dicht durchquert und die verstärkten Signale durch einen Ausgangskoppler (26), der den Behälter (11) dicht durchquert, überträgt, wobei der Raum mit Hilfe eines Wärmepumpkühlköpfes (30) im Inneren des Behälters (11) gekühlt wird, **dadurch gekennzeichnet, dass** in dem Funkfrequenzverstärker (10):
- die Eingangs- (23) und Ausgangskoppler (26) für einen Strukturteil mit einem Material mit einer Wärmeleitfähigkeit gleich oder kleiner als 50 W/m.K und für einen elektrisch leitenden Teil durch Aufbringen eines Materials mit einer elektrischen Leitfähigkeit über 10E7 Siemens/m auf den Strukturteil hergestellt sind;
- der Innendruck in dem Kryostatbehälter (11) vor der Verringerung der Temperatur einem Niedervakuumdruck oder Primärvakuumdruck zwischen dem Luftdruck und 10 Pa entspricht;
- der hermetisch dichte Raum, der von dem Behälter (11) begrenzt ist, mit einem Nanostruktur-Wärmeisoliermaterial auf Basis von Siliziumoxid in Form eines Aerogels gefüllt ist;
- der Kühlkopf (30) mindestens zwei Stufen (302, 303) umfasst, deren Kühlenden (304, 305) unterschiedliche kryogene Temperaturen haben, wobei eine Endstufe (305) bei einer Temperatur nahe der Temperatur, bei der der rauscharme Verstärker (25) funktionieren soll, funktioniert, und mindestens eine Zwischenstufe bei einer Zwischentemperatur zwischen der Temperatur der Endstufe und einer Raumtemperatur funktioniert, wobei ein kühler Endabschluss (315) der Endstufe (305) thermisch mit dem rauscharmen Verstärker (25) verbunden ist (315, 316), so dass ein Pumpen der Wärme des rauscharmen Verstärkers erfolgt, und wobei ein kühler Zwischenabschluss (304) der mindestens einen Zwischenstufe (302) thermisch mit Stützstrukturen (27) oder inneren Elementen des Verstärkers (10) verbunden ist (314), so dass ein Pumpen der Wärme, die im Inneren des Behälters (11) verbreitet wird, erfolgt.

2. Funkfrequenzverstärker nach Anspruch 1, bei dem der Eingangskoppler (23) und/oder der Ausgangskoppler einen Wellenleiter (232) umfassen, der dicht eine Wand des Kryostatbehälters (11) im Bereich eines Wellenleiterfensters (231) durchquert, wobei der Wellenleiter Wände umfasst, deren Struktur mit dem Material mit einer Wärmeleitfähigkeit gleich oder kleiner als 50 W/m.K hergestellt ist, und wobei eine Innenfläche des Wellenleiters mit einer Schicht des Materials mit einer elektrischen Leitfähigkeit über 10E7 Siemens/m bedeckt ist.

3. Funkfrequenzverstärker nach Anspruch 1, bei dem der Ausgangskoppler (26) und/oder der Eingangskoppler ein Koaxialkabel (261) umfassen, das dicht eine Wand des Kryostatbehälters (11) im Bereich eines Koaxialanschlusses (262) durchquert, wobei das Koaxialkabel einen zentralen Leiter umfasst, der mit dem Material mit einer Wärmeleitfähigkeit gleich oder kleiner als 50 W/m.K hergestellt ist, und wobei eine Außenfläche des zentralen Leiters mit der Schicht des Materials mit einer elektrischen Leitfähigkeit über 10E7 Siemens/m bedeckt ist, und wobei das Koaxialkabel ein Schirmgeflecht umfasst, das aus einem metallischen Material mit einer Wärmeleitfähigkeit gleich oder kleiner als 50 W/m.K hergestellt ist.

4. Funkfrequenzverstärker nach Anspruch 2 oder 3, bei dem das Material mit einer Wärmeleitfähigkeit gleich oder kleiner als 50 W/m.K ein metallisches Material ist, das der Familie der rostfreien Stähle oder der Eisen-Nickel-Legierungen angehört, umfassend ungefähr 36 % Nickel oder ein keramisches Material oder ein Verbundmaterial, umfassend Fasern, die in einem gehärteten Harz gehalten werden.

5. Funkfrequenzverstärker nach Anspruch 4, bei dem das Material mit einer elektrischen Leitfähigkeit über 10E7 Siemens/m der Familie der Metalle oder Metalllegierungen angehört, umfassend Silber Ag, Gold Au oder Kupfer Cu.

6. Funkfrequenzverstärker nach einem der vorhergehenden Ansprüche, bei dem der Kühlkopf (30) an dem Kryostatbehälter (11) von außerhalb des Kryostats mit Hilfe einer dicht mit dem Behälter verbundenen Büchse (31) befestigt ist.

7. Furzkfrequenzverstärker nach Anspruch 6, bei dem die Büchse (31) eine innere Büchse (312, 313) umfasst, die eine Hülle bildet, die den Behälter (11) im Bereich einer Öffnung (113) durchquert, in der die Zwischen- (302) und Endstufen (303) des Kühlkopfes (30) gehalten werden, wobei Kühlenden (304, 305) des Kühlkopfes direkt oder indirekt in thermischer Kontinuität mit inneren Elementen (232, 24, 25, 261, 27) des Verstärkers mit Hilfe von thermischen Verbindungen (314, 315), die mit der Büchse (31) verbunden sind, angeordnet sind.

8. Funkfrequenzverstärker nach Anspruch 7, bei dem die thermische Kontinuität zwischen einem Kühlende (304, 305) des Kühlkopfes (30) und einer ihm entsprechenden mit der Büchse (31) verbundenen thermischen Verbindung (314, 315) durch Kontakt oder Festklemmen gewährleistet wird, wenn die Temperatur abgesenkt wird, und ohne Festklemmen, wenn die Temperatur des Verstärkers nahe der Raumtemperatur ist.

9. Funkfrequenzverstärker nach Anspruch 8, bei dem die innere Büchse (312, 313) Öffnungen (319) zur Verbindung zwischen einem Innenvolumen der von der inneren Büchse gebildeten Hülle und dem Innenvolumen des Kryostatbehälters umfasst.

10. Funkfrequenzverstärker nach einem der vorhergehenden Ansprüche, bei dem Zubehörteile der Verstärkungskette in dem Kryostat angeordnet sind, um auf kryogener Temperatur gehalten zu werden, wobei die Zubehörteile einer der Kategorien der Filter (24), die auf die Bandbreite der Signale einwirken, der Isolatoren, die auf die Reflexionen der Signale einwirken, der Signalkoppler angehören.

11. Funkfrequenzverstärker nach einem der vorhergehenden Ansprüche, bei dem ein System zum Wärmen des Funkfrequenzverstärkers im Inneren des Kryostatbehälters (11) angeordnet ist.

## Claims

1. Radiofrequency amplifier (10) for low power radiofrequency signal reception device including a low noise amplifier (25) maintained in a hermetically sealed space delimited by an envelope (11) of a cryostat in which space a reduced interior pressure is maintained compared to the external atmospheric pressure, said low noise amplifier receiving signals to be amplified from an input coupler (23) crossing the envelope (11) in a sealed manner, and transmitting the amplified signal through an output coupler (26) crossing the envelope (11) in a sealed manner, said space being cooled by a heat pumping cold head (30) inside the structure **characterised in that** in the radiofrequency amplifier (10):
- The input (23) and output (26) couplers are made, for a structural part, from a material with thermal conductivity equal or less than to 50W/m.K, and for an electrically conductive part by a plating on said structural part made of a material with electrically conductivity higher than 10E7 Siemens/m.
- The internal pressure in the envelope (11) of the cryostat, before its temperature is reduced, corresponds to a low grade or primary vacuum pressure of between atmospheric pressure and 10Pa.
- The hermetic space delimited by the envelope (11) is filled with a silicon based nano-structured thermal insulation in the form of an aerogel.
- The cold head (30) includes at least two stages (302, 303) whose cold terminations (304, 305) are at different cryogenic temperatures, a base stage (303) operating at a temperature close to the temperature at which the low noise amplifier (25) must operate and at least one intermediate stage (302) operating at a temperature between that of the base stage and ambient temperature, a cold termination (305 of the base stage (303) being thermally linked (315, 316) to the low noise amplifier (25) in order to implement heat pumping of said low noise amplifier and an intermediate cold termination (304) of the at least one intermediate stage (302) being thermally linked (314) to support structures (27) or to internal elements of the amplifiers (10) in order to achieve distributed heat pumping inside the envelope (11).

2. Radiofrequency amplifier as in Claim 1, in which the input coupler (23), and or the output coupler, includes a waveguide (232) crossing the envelope (11) of the cryostat in a sealed manner at the level of waveguide windows, said waveguide including structural walls made with a material with thermal conductive equal or less than 50W/m.K, and with the waveguide internal surface covered with plating material with an electrically conductivity of more than 10E7 Siemens/m.

3. Radiofrequency amplifier as in Claim 1, in which the output coupler (26), and or the input coupler, includes a coaxial cable (261) crossing a wall of the envelope (11) of the cryostat in a sealed manner at the level of a coaxial connector (262), said coaxial cable including a central conductor made with a material with thermal conductive equal or less than 50W/m.K, and with the external surface covered with plating material with an electrically conductivity more than 10E7 Siemens/m, and the said coaxial cable including a shield made from a metallic material with a thermal conductivity equal or less than 50W/m.K.

4. Radiofrequency amplifier as in Claim 2, or as in Claim 3, in which the material with thermal conductivity equal or less than 50W/m.K is a metallic material belonging to the stainless steel or iron-nickel alloy family including around 36% nickel or a ceramic material or a composite material including fibres maintained in a hardened resin.

5. Radiofrequency amplifier as in Claim 4, in which the material with electrical conductivity more than 10E7 Siemens/m belongs to the metal or alloy metal family including silver Ag, gold Au or copper Cu.

6. Radiofrequency amplifier as in one of the previous Claims, in which the cold head (30) is attached to the envelope (11) of the cryostat from the outside of said cryostat through a sealed, secured socket (31) to the said envelope.

7. Radiofrequency amplifier as in Claim 6, in which the socket (31) includes an internal tube (312, 313) forming a sheath crossing the envelope (11) through an opening (113), in which are held the intermediate (302) and base (303) stages, cold terminations (304, 305) of said cold head (30) being directly, or indirectly, in thermal continuity with the amplifiers internal elements (232, 24, 25, 261, 27) through thermal links (314, 315) fixed to the socket (31).

8. Radiofrequency amplifier as in Claim 7, in which the thermal continuity between the cold terminations (304, 305) of the cold head (30) and a corresponding thermal link (314, 315) fixed to the socket (31) is ensured by contact or by clamping when the temperature of the amplifier is low and without clamping when the temperature of the amplifier is close to ambient temperature.

9. Radiofrequency amplifier as in Claim 8, in which the internal tube (312, 313) includes communication passages (319) between the internal volume of the sheath formed by said tube and the internal volume of the cryostat envelope.

10. Radiofrequency amplifier as in one of the previous Claims, in which accessory components of the amplification chains are arranged in the cryostat so that they are maintained at cryogenic temperature, said accessory components belonging to one of the category of filters (24) acting on the bandwidth of the signals, of the isolators acting on the signals reflection, of signal couplers.

11. Radiofrequency amplifier as in one of the previous Claims, in which a re-heating system of said radiofrequency amplifier is arranged inside the envelope (11) of the cryostat.
